# EUROPEAN PATENT SPECIFICATION

(11) **EP 0 581 366 B1**
(45) Date of publication and mention of the grant of the patent: **02.04.1997**
(21) Application number: 93202094.4
(22) Date of filing: 16.07.1993
(51) Int. Cl.: H01L 39/14, H01L 39/24

(54) **Process of producing a coaxial electrical cable with ceramic superconductor material having a high transition temperature**
Verfahren zur Herstellung eines elektrischen Koaxialkabels mit keramischem Hochtemperatur-Supraleitermaterial
Procédé de fabrication d'un cable électrique coaxial à matière céramique supraconducteur à haute température

(30) Priority: 28.07.1992 IT MI921826
(43) Date of publication of application: 02.02.1994
(73) Proprietor: CISE S.p.A., I-20123 Milan (IT)
(72) Inventor: Martini, Luciano, I-20065 Inzago (Milano) (IT)
(74) Representative: Mittler, Enrico

(56) References cited:
- EP-A- 0 280 322
- EP-A- 0 401 461
- EP-A- 0 472 333
- DE-A- 1 257 436
- DE-A- 3 729 125
- PATENT ABSTRACTS OF JAPAN, vol. 15, no. 250 (E-1082) 26 June 1991 & JP-A-03 078 915
- Advanced Ceramic Materials, Vol.2, No.3B, 1987,pages 388-400; R.W.McCallum et al.: "Problems in the production of YBa2Cu3Ox superconducting wire"

## Description

The present invention relates to a process for the production of coaxial electrical cables of ceramic superconductor material having a high transition temperature.

Superconductors are materials whose electrical and magnetic characteristics undergo a sudden variation when the material is cooled below a temperature characteristic of the material itself, generally indicated with the term transition temperature.

As regards electrical characteristics, the attainment of the transition temperature produces a sudden elimination of the resistivity of the material, so that this can transmit extremely high electrical currents with a negligible dissipation effect. The condition of superconductivity is maintained until the temperature remains below the transition temperature and it can also be eliminated through the application of an external magnetic field with an intensity higher than a critical transition value that is also characteristic of the material.

From the point of view of magnetic characteristics, the condition of superconductivity has the effect of making the material completely impermeable to external magnetic fields; it is thus possible to use superconductor materials for screening magnetic fields.

It is evident that the possibility of developing in the applicative sense any knowledge regarding supeconductors, above all as regards the transmission of electrical currents, imposes the use of materials that have a temperature of transition to the condition of superconductor that is as high as possible.

Such a possibility is offered in a particular way by ceramic superconductor materials. For such materials in fact the transition temperature is around 125°K, that is -148°C, while traditional superconductors operate only at temperatures below 25°K.

Known techniques for the production of electrical cables containing ceramic superconductor materials having a high transition temperature (so-called SATT) allow the production of single- or multi-filament cables in which one or more wires or tapes of ceramic superconductor material separated from one another are sheathed externally by a containment structure. The material constituting such a containment structure, for example silver, should possess chemical characteristics such as to prevent it from reacting with the ceramic powders and electrical characteristics such as to allow the conduction of high electrical currents even in the absence of superconductivity. Good thermal conductivity is also desirable so as to ensure thermal stability of the cable itself.

The production of such cables takes place using ceramic powders that are inserted inside the abovementioned containament structure and are subsequently pressed to obtain good cohesion between the granules of ceramic powder. Better cohesion can be obtained through thermal processes.

The best cables produced up to now through such a technique are tapes having a very low thickness (for example, less than 0.2 mm) that possess outstanding characteristics as regards density of compactness and degree of orientation of the lamellar grains of the ceramic superconductor used, indispensable characteristics for obtaining superconductor cables with high qualities for transmitting electrical current.

The abovementioned tapes, however, due to the limited quantity of superconductor material present in their transversal cross-section, are not yet in a position of allowing the desired transmission of high electrical currents, higher than 40-50 A at 77°K in the absence of a magnetic field.

Among the causes that have up to now prevented the attainment of the desired development, the need should certainly be numbered of eliminating a contradiction inherent in the characteristics of powder ceramic superconductors.

On the one side, in fact, the transmission of high currents requires the use of large quantities of superconductor material in the transversal cross-section of the cables themselves. On the other, it has also been noticed that limited thicknesses of superconductor material ensure better characteristics of the final product, so that it would appear useless to develop techniques suitable simply for increasing the diameter of the wires produced by means of the abovementioned known technique.

A possibility of eliminating the abovementioned drawbacks consists in developing techniques designed to the assembly of several tapes in parallel with one another, so as to obtain composite tapes having a larger transversal cross-section of superconductor material and, thus, with a substantial increase in the quantity of superconductor material present in the cross-section itself.

The main drawback of such a technique is represented by the fact that the assembly of individual tapes is not carried out easily, above all in relation to the geometry of the conductors themselves, that are extremely long and thin.

Assembly leads above all to problems linked with the possibility of loss of alignment and cohesion of the wires, with the consequent reduction in the capacity of transmission and redistribution of electrical current through the cable's cross-section.

JP-A-03 078 915, EP-A-0 472 333 and EP-A-0 401 461 disclose an electrical cable consisting of ceramic superconductor material having a high transition temperature, which is formed by coaxial tubular layers alternated with tubular sheaths of electrically conducting metallic material inside a tubular containment structure of an electrically conducting metallic material.

In this way electrical cables having a coaxial structure (circular or substantially rectangular according to requirements) are obtained that, containing large quantities of superconductor material, are capable of transmitting high electrical currents without requiring to be assembled with similar cables for obtaining such an object. Of fundamental importance should the fact be considered in particular that the large quantity of superconductor material present is not linked to an increase in the thickness of the individual layers of superconductor material; thus the good characteristics of cohesion and orientation linked with such a characteristic are not altered.

Said coaxial structure also allows a substantial increase in the surface interfacing between the superconductor and the metallic conductor that constitutes the supporting structure.

The coaxial structure lastly allows the maximization of the effect of screening from external magnetic fields, since in such a configuration each superconductor layer is shielded by the more external layers.

The above mentioned prior documents also disclose a production process suitable for the manufacture of superconductor cables having a coaxial structure as described above.

The object of the present invention is to provide an improved process for manufacturing coaxial-structure superconductor cables.

The process according to the invention is defined in claim 1.

The features of the present invention shall be made evident by the following detailed description of its embodiments, illustrated as non-limiting examples in the enclosed drawings, wherein:
Fig. 1 shows a coaxial cable having a circular cross-section in a transversal sectional view;
Fig. 2 shows a coaxial cable having a substantially rectangular cross-section, again in a transversal sectional view;
Fig. 3 shows, in a transversal sectional view, a cable having a circular cross-section, obtained by assembling several coaxial cables having a circular section;
Fig. 4 shows, in a transversal sectional view, a cable having a circular cross-section, obtained by assembling several coaxial cables having a rectangular cross-section;
Fig. 5 shows one step of the process according to the invention for the production of coaxial cables;
Fig. 6 shows a further step of the process for the production of coaxial cables.

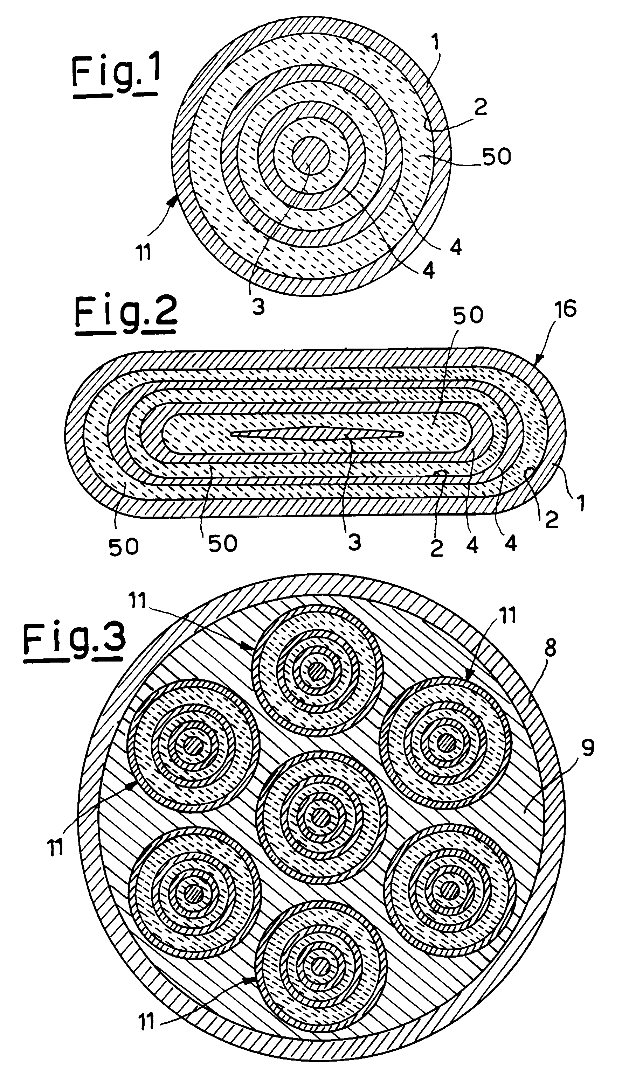

With reference to Fig. 1, a coaxial cable having a circular cross-section comprises a hollow external cylindrical containment structure 1, constituted in a manner known in itself by an electrically conducting metallic material (for example, silver) that does not react with the ceramic powders used for obtaining the superconductor.

At the axis of such a containment structure 1, there is a cylindrical core 3 of the same conductor material constituting the containment structure 1. Such a core 3, illustrated with a full cross-section, can as an alternative be formed with a hollow cross-section for the passage of a possible refrigerating fluid.

Coaxially with such central core 3 and internally to the containment structure 1 there are also intermediate sheaths 4 of the same material that are also in the form of hollow cylinders, whose dimensions have been chosen so as to always allow the formation of a space 2 between one sheath 4 and the next or between one of these and the central core 3 or the containment structure 1.

The metallic structures 1, 3 and 4 constitute as a whole a coaxial supporting structure for layers 50 of ceramic superconductor material having a high transition temperature (SATT) that fill the spaces 2 of the abovementioned structure. Such superconductor layers 50 thus alternate in a regular manner with the metallic sheaths 4 and are on the whole limited internally by the internal core 3 and externally by the containment structure 1. The quantity of superconductor present in the cable depends on the number and on the thickness of the layers 50 used. In this respect it should be noted that, according to the object of the present invention, the coaxial metallic structure can be constituted in such a way as to allow the formation of thin layers of superconductor 50, so as to obtain the best operational characteristics of the cable 11.

One advantage offered by the cable 11 is linked to the magnetic insulation of the cable itself; each of the layers of superconductor 50, in fact, constitutes a screen for the layers 50 located internally to it.

In addition, the presence of a metallic structure constituted completely by conductor material leads to a guarantee of operational continuity in the case where accidental causes (for example, the raising of the temperature above the transition temperature or the immersion of the superconductor in a magnetic field with an intensity higher than that of the critical field) cause the transition of the superconductor constituting the layers 50 to a non-superconductor state.

Since good electrical conductivity is also generally correlated with good thermal conductivity, the extensive interfacing surface between the superconductor layers 50 and the metallic structures 1, 4 and 3 guarantees an even better thermal stability of the cable 11 obtained.

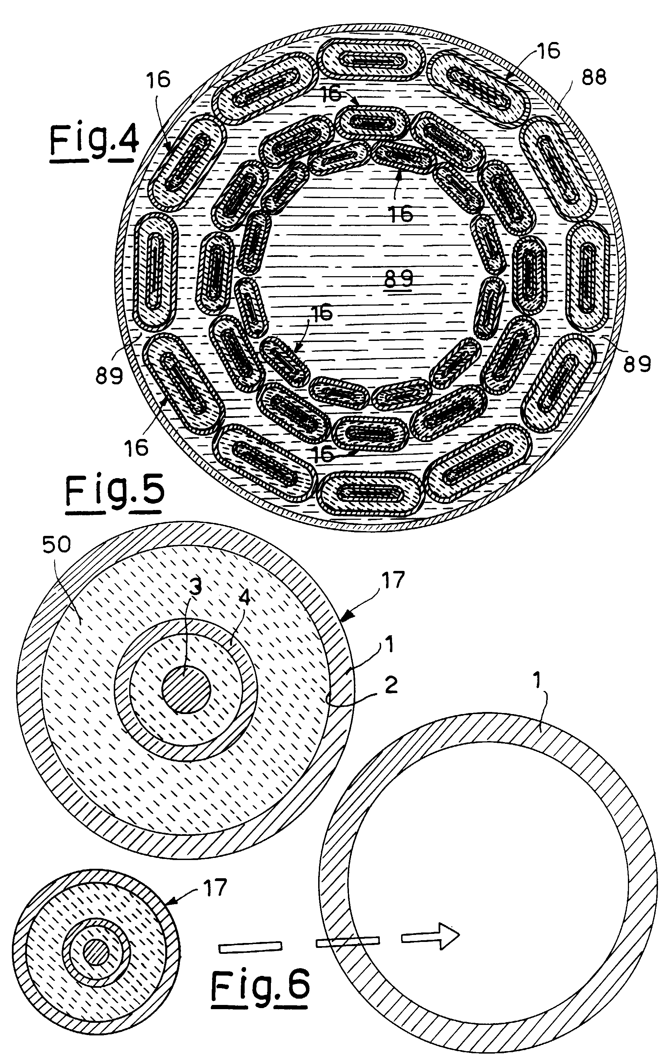

With reference to Fig. 2, a structure similar to that of the coaxial cables having a circular cross-section 11 is that of the coaxial cables having a substantially rectangular cross-section, or coaxial tapes, 16; with respect to the cables 11, the geometry of the various tubular elements in the cables 16 varies, and from circular it becomes almost rectangular with one dimension extremely extended with respect to the other.

For the rest the structure of the cable remains unchanged; in this case again, in fact, the coaxial supporting structure is constituted by an external sheath 1, by a metallic central core 3 and by intermediate metallic sheaths 4, between which there are cavities 2, suitable for receiving as many layers 50 of superconductor material.

It is evident that, in addition to the abovementioned circular (Fig. 1) and rectangular (Fig. 2) geometries, the coaxial cables according to the invention can also have different geometries, while still maintaining unchanged structural characteristics.

With reference to Fig. 3, coaxial cables having a circular cross-section 11 of the type represented in Fig. 1 can be assembled with one another making use of a further cylindrical external containment structure 8 also made of the conductor material that constitute the abovementioned structures 1, 4 and 3, containing a plurality of parallel coaxial cables 11, of the type represented in Fig. 1, kept separate one from the other by a filling material 9 (metal or other substance) with an appropriate resistivity value.

In this way electrical cables are obtained that, thanks to the filling material 9 and to the dissipation of heat ensured by the external sheath 8, are thermally stabilized and particularly suitable for reducing losses in alternating current.

With reference to Fig. 4, coaxial cables having a rectangular cross-section 11 of the type represented in Fig. 2 can be assembled with one another making use of a further external containment structure 88 containing two groups of concentric circumferential successions of tapes 16. The abovementioned groups are kept electrically insulated from one another and in thermal contact through the use of a refrigerating liquid 89, such as nitrogen or liquid helium. Again in this case the main application is constituted by the transmission of alternating current, for which such a type of cable exhibits very low losses. A further feature is also the outstanding thermal stability.

With reference to Fig. 5, the process of production of the coaxial cables 11 and 16 can be executed as follows.

Starting with the metallic supporting structure constituted, as has been said, by a central cylindrical core 3, a plurality of tubular sheaths 4 and an external containment structure 1, ceramic powder SATT is inserted in the cavities 2 included between said structures 1, 3 and 4.

The extensive interfacing surface between the layers 50 of the conductor and the conductor surfaces of the metallic supporting structure allows an acceleration of the processes of growth and orientation of phases and compounds that make it easier for the ceramic superconductor material having a high transition temperature to grow and orient itself.

The ceramic powder inserted in the cavities 2 is compacted by suitable means, for example by simple axial compression by means of pipes of suitable dimensions.

The coaxial structure 17 thus obtained (Fig. 5) is then closed at both extremities and subjected to a hot and/or cold mechanical processing procedure with the object of reducing its diameter. Among the mechanical treatments used for such a purpose transversal compression, hammering, extrusion and drawing should be mentioned, all operations that can be hot- or cold-executed. For each cycle of the mechanical process reductions in diameter of about 10% are generally obtained.

During the various operations connected with such a mechanical process one or more high-temperature annealing treatments are sometimes executed (for example, at 600°C for 12 hours in air), with the object of releasing the mechanical stresses accumulated in the metallic structure that has been strongly work hardened as a result of the mechanical process itself.

Once the desired dimensions and shape have been obtained, the structure 17 is subjected to a thermal sintering treatment of the ceramic powder, that has the object of enhancing the characteristics of electrical cohesion between the granules of the ceramic supeconductor.

The thermal treatments used should in any case be conducted at a temperature lower that the melting point of the conductor material constituting the metallic structure 1, 3, 4 and can be repeated more than once, until the desired characteristics have been obtained. As an example, for a ceramic superconductor such as that indicated with the stoichiometric composition (Bi, Pb)₂ Sr₂ Ca₂ Cu₃ Oy, the sintering treatment is executed at 830°C for 50 or 100 hours in an Argon-Oxygen atmosphere containing 10% of oxygen by moles, or at 845°C for 50-100 hours in air.

The coaxial structure 17 thus obtained (Fig. 5) already in itself constitutes a superconductor coaxial cable. But since technical difficulties prevent use to be made of an initial structure with a high number of sheaths 4, in order to obtain a high number of layers 50 it is generally preferred to proceed by successive steps.

For this purpose a structure 17 is first produced, of the type just described, containing a low number of sheaths 4 and, thus, of layers 50. Such a structure 17 is then used as the central cylindrical core for a new coaxial structure (Fig. 6), which is subjected to the same treatments described previously.

Such a procedure can then be repeated again, so that by reiterating the process a coaxial cable 11 is obtained (Fig. 1) containing the desired number of layers 50.

The production process leading to the formation of coaxial cables having a rectangular cross-section 16 starts with the same operations described for coaxial cables having a circular cross-section 11 and illustrated in Fig.s 4 and 5.

In the case of the production of cables having a rectangular cross-section 16, however, a further production step is necessary consisting in a succession of rolling operations of the cable 11 suitable for squeezing the same until its cross-section becomes almost rectangular. It is evident that such a geometric change refers both to the metallic structure and to the layers 50 of superconductor material.

A coaxial cable is thus obtained in the form of a tape of the type of Fig. 2, whose characteristics, in particular orientation and cohesion of the granules of ceramic powder constituting the superconductor material, can be optimized by means of further thermal treatments at high temperature.

## Claims

1. Process for the production of a coaxial electrical cable of a ceramic superconductor material having a high transition temperature, characterized by the following succession of steps:
a) preparation of a coaxial supporting structure (1, 3, 4) formed by a central core (3) and a plurality of coaxial tubular sheaths (1, 4) of electrically conducting metallic material, which define coaxial tubular cavities (2) therebetween;
b) introduction of a powder (50) of a high temperature ceramic superconductor into said coaxial cavities (2) of the coaxial supporting structure (1, 3, 4);
c) mechanical axial compression of the ceramic superconductor powder (50) in all said coaxial cavities (2);
d) mechanical transversal compression of the coaxial supporting structure (1, 3, 4) filled with axially compressed superconductor ceramic powder (50);
e) thermal treatment.

2. Process according to claim 1, characterized in that said steps of transversal compression and thermal treatment are repeated several times, also in an inverted order.

3. Process according to claim 1, characterized in that it comprises successive production cycles, wherein a cable (17) produced in each cycle is used as the central core (3) of a coaxial supporting structure (3, 4, 1) for the subsequent cycle, until the desired dimensions are reached.

4. Process according to claim 1 or 3, characterized in that a cable having a circular cross-section (11) is transformed in a cable having a rectangular cross-section (16) by executing the following steps in succession:
a) rolling of the cable (11), until the desired shape is reached;
b) cycle of thermal treatments.

## Patentansprüche

1. Verfahren zur Herstellung eines elektrischen Koaxialkabels aus einem keramischen Supraleitermaterial, welches eine hohe Sprungtemperatur hat, **gekennzeichnet durch** die Abfolge folgender Schritte:
a) Herstellen einer koaxialen Stützkonstruktion (1, 3, 4), welche von einem zentralen Kern (3) und einer Mehrzahl von koaxialen, hülsenförmigen Mantelteilen (11, 4) aus elektrisch leitendem, metallischen Material gebildet wird, welche koaxiale, rohrförmige Hohlräume (2) dazwischen bilden;
b) Einbringen eines Pulvers (50) eines keramisch Hochtemperatur-Supraleiters in die koaxialen Hohlräume (2) der koaxialen Stützkonstruktion (1, 3, 4);
c) mechanisches axiales Verdichten des keramischen Supraleiterpulvers (50) in allen koaxialen Hohlräumen (2);
d) mechanisches quergerichtetes Verdichten der koaxialen Stützkonstruktion (1, 3, 4) aufgefüllt mit dem axial verdichteten keramischen Supraleiterpulver (50);
e) Wärmebehandeln.

2. Verfahren nach Anspruch 1, **dadurch gekennzeichnet,** daß die Schritte zum quergerichteten Verdichten und die Wärmebehandlung auch in einer umgekehrten Reihenfolge mehrmals wiederholt ausgeführt werden.

3. Verfahren nach Anspruch 1, **dadurch gekennzeichnet,** daß es aufeinanderfolgende Herstellungszyklen aufweist, bei denen ein Kabel (17), welches in jedem Zyklus hergestellt worden ist, als zentraler Kern (3) einer koaxialen Stützkonstruktion (3, 4, 1) für den anschließenden Zyklus genommen wird, bis man die gewünschten Abmessungen erreicht hat.

4. Verfahren nach Anspruch 1 oder 3, **dadurch gekennzeichnet,** daß ein Kabel, welches einen kreisförmigen Querschnitt (11) hat, in ein Kabel umgeformt wird, welches einen rechteckförmigen Querschnitt (16) hat, in dem die folgenden Schritte in Abfolge ausgeführt werden:
a) Walzen des Kabels (11), bis die gewünschte Gestalt erreicht ist;
b) Durchführen eines Zyklus mit Wärmebehandlungen.

## Revendications

1. Procédé de production d'un câble électrique coaxial d'un matériau céramique supraconducteur ayant une température élevée de transition, caractérisée par la succession suivante d'étapes :
a) la préparation d'une structure coaxiale de support (1, 3, 4) formée par une âme centrale (3) et plusieurs gaines tubulaires coaxiales (1, 4) d'un matériau métallique conducteur de l'électricité qui délimitent entre elles des cavités tubulaires coaxiales (2),
b) l'introduction d'une poudre (50) d'un supraconducteur céramique à température élevée dans les cavités coaxiales (2) de la structure coaxiale de support (1, 3, 4),
c) la compression mécanique axiale de la poudre supraconductrice céramique (50) dans toutes les cavités coaxiales (2),
d) la compression mécanique transversale de la structure coaxiale de support (1, 3, 4) remplie de la poudre céramique supraconductrice comprimée axialement (50), et
e) un traitement thermique.

2. Procédé selon la revendication 1, caractérisé en ce que les étapes de compression transversale et de traitement thermique sont répétées plusieurs fois, et dans un ordre inversé aussi.

3. Procédé selon la revendication 1, caractérisé en ce qu'il comprend des cycles successifs de production, dans lesquels un câble (17) produit dans chaque cycle est utilisé comme âme centrale (3) d'une structure coaxiale de support (3, 4, 1) pour le cycle suivant, jusqu'à l'obtention des dimensions voulues.

4. Procédé selon la revendication 1 ou 3, caractérisé en ce qu'un câble de section circulaire (11) est transformé en un câble de section rectangulaire (16) par exécution successive des étapes suivantes :
a) le laminage du câble (11) jusqu'à l'obtention de la configuration voulue, et
b) l'exécution d'un cycle de traitements thermiques.
